# EUROPEAN PATENT SPECIFICATION

(11) **EP 3 893 064 B1**
(45) Date of publication and mention of the grant of the patent: **04.11.2026**
(21) Application number: 20168413.1
(22) Date of filing: 07.04.2020
(51) Int. Cl.: G05B 13/02, G05B 13/04

(54) **METHOD FOR PREDICTING STATUS OF MACHINING OPERATION**
VERFAHREN ZUR VORHERSAGE DES ZUSTANDS EINER BEARBEITUNGSOPERATION
PROCÉDÉ DE PRÉDICTION DE L'ÉTAT D'OPÉRATION D'USINAGE

(43) Date of publication of application: 13.10.2021
(73) Proprietor: United Machining Mill AG, 2504 Biel/Bienne (CH); Inspire AG, 8005 Zürich (CH)
(72) Inventor: Postel, Martin, 8005 Zürich (CH)
(74) Representative: Arend, Christa

(56) References cited:
- US-A1- 2018 164 757
- POSTEL M ET AL: "Ensemble transfer learning for refining stability predictions in milling using experimental stability states", THE INTERNATIONAL JOURNAL OF ADVANCED MANUFACTURING TECHNOLOGY, SPRINGER, LONDON, vol. 107, no. 9-10, 24 April 2020 (2020-04-24), pages 4123 - 4139, XP037133532, ISSN: 0268-3768, [retrieved on 20200424], DOI: 10.1007/S00170-020-05322-W
- HARISH CHERUKURI ET AL: "Machining Chatter Prediction Using a Data Learning Model", JOURNAL OF MANUFACTURING AND MATERIALS PROCESSING, vol. 3, no. 2, 8 June 2019 (2019-06-08), pages 45, XP055721623, DOI: 10.3390/jmmp3020045

## Description

### FIELD OF THE INVENTION

The present invention is related to a method for predicting status of machining operation, in particular chatter occurrence.

### BACKGROUND OF INVENTION

Today, prediction plays an important role in most of the technical fields. For example, methods for predicting errors occurring during production, quality of produced product as well as status of machining operation are widely deployed.

Different techniques have been developed in the past to conduct the prediction. However, the accuracy of the prediction is not sufficiently high to fulfill the requirements for certain applications. Therefore, enhancing the accuracy of the prediction is more and more demanded. Furthermore, if the prediction is applied in an industrial environment, the effort to make the prediction should be low.

One approach to make a prediction is based on physical models such as analytical model and numerical model. For example, model for stress and strain induced by external forces acting on a system, modeling the thermal behavior of a system or stability of a system. In order to provide a precise prediction, the physical phenomena must be well understood. Limited capacity of understanding and characterizing certain phenomena leads to erroneous physical models or unreliable prediction due to large uncertainty regarding model parameters.

**These days,** machine learning is another well-known approach to perform a prediction. However, in order to obtain a precise prediction, large amounts of experimental data are required. In industrial fields, it can be a challenging task to collect a large amount of experimental data.

US 2020/0073343 discloses a machine learning method for optimizing the coefficients of a filter provided in a motor control device that controls rotation of a motor for a machine tool.

In machining industries, predicting the status of the machining operation is becoming increasingly important to improve the quality of the production and to enhance the productivity. For example, in milling process the machining instability, namely chatter can reduce the quality of the produced part, drastically increase the wear of the cutting tool and even damage the machine tool. In further, to ensure a stable, chatter free machining, the process parameters are often chosen very conservatively. Therefore, chatter vibrations belong to the most critical phenomena limiting the productivity.

One known approach to predict chatter is using physical models. Stability lobes diagrams are normally used to represent the prediction results. The stability lobe diagram indicates if a machining operation is stable or unstable under specific cutting conditions. From the stability lobe diagram, the optimal process parameters for a stable machining and maximal productivity can be selected. Typically, stability lobe diagrams separate the regions between stable and unstable cutting depths as a function of the spindle speed.

The article "machining chatter prediction using a data learning model" is related to a method of applying an artificial neural network to model turning stability. A physics-based process model is used to generate data set for training the neural network. Cherukuri, H. Journal of Manufacturing and materials process. 2019, 3, 45.

EP 2916187 is related to a chatter database system, which includes a central chatter database, which is fed with data corresponding to the machining and chatter conditions of machining tools, particularly a milling, turning, drilling or boring machine. The invention is characterized by the features that the data fed to the central chatter database is obtained and collected from at least two individual machining tools included in the chatter database system. Whereby the data is sent to the central chatter database via a data connection, preferably via a secured network, to generate chatter stability maps based on real encountered conditions.

Yet, it is often observed that the experimental stability limits differ from the theoretical ones. On the one hand, this is because the stability models yielding the theoretical stability limits are inaccurate. On the other hand, this is caused by the parameters required to these models, which may not be precisely known during cutting operation. The uncertainties of the parameters of the stability model have a direct impact on the reliability of the output of the stability model. Since both, model-based and experimental methods to obtain these model parameters usually demand intense preparation and analysis, in recent years it was also tried to utilize machine learning techniques for the prediction of stability limits. This approach however requires a large number of samples to learn the shape of the stability lobes, which is also one of the reasons why only simulated data was used. Furthermore, the methods are limited to one specific tool-holder combination with one defined tool length and workpiece material, which means that all training points need to be acquired under these defined conditions.

### SUMMARY OF THE INVENTION

It is an objective of this invention to provide a method for predicting status of machining operation with an improved accuracy and reliability. In particular, it is an objective to provide a method for predicting chatter in a machine tool, which can be deployed in an industry environment.

According to the present invention, these objectives are achieved through the features of independent claims, which define the invention.

In addition, further advantageous embodiments follow from the dependent claims and the description.

In the present invention, a method for predicting status of machining operation, in particular chatter occurrence comprises training a neural network in a pre-training phase and a final-training phase. The neural network has an input layer, at least one hidden layer, an output layer and a plurality of weights. In the pre-training phase, a pre-training data set is provided to the neural network to obtain a pre-trained neural network. In the final-training phase, a final-training data set is fed to the pre-trained neural network to obtain a final-trained neural network. The pre-training data set comprises simulated data and the final-training data set comprises experimental data. The method further comprises performing prediction by utilizing the final-trained neural network to derive prediction data.

A multi-layer classification neural network is trained first in the pre-training phase with simulated data generated from a physical model, in particular the physical model represents the status of machining operation. In the pre-training phase, the goal is to make the pre-trained neural network learn the general dependencies of the inputs and outputs of the physical model.

In the final-training phase, the pre-trained network is then fed with the final-training data set including experimental data to fine-tune the pre-trained neural network with experimentally measured data and allow for more accurate predictions in future processes. The experimental data is related to the status of machining operation and is obtained in the machining condition.

In this manner, the prediction accuracy can be increased and the measurement effort can be kept to a minimum. These advantages are essential for deploying this method in an industrial field. The required experimental data for fine-tuning can be collected during regular production.

After the pre-training phase, the pre-trained neural network has weights, which are determined during the pre-training using simulated data. The weights of the pre-trained neural network are used as the initial value for the final-training phase. During the final-training phase, the weights of the pre-trained neural network are adapted by feeding the final-training data set, which is in particular experimental data.

In an advantageous variant, the amount of the data included in the pre-training data set is significantly larger than the amount of data included in the final-training data set, in particular, the amount of the data included in the pre-training data set is at least ten times larger than the amount of data included in the final-training data set.

In one preferred embodiment, the pre-training data set comprises exclusively simulated data generated from the physical model and/or the final-training data set comprises exclusively experimental data. The simulated data can be generated separately outside the production environment. Therefore, large amounts of simulated data can be acquired without needing to perform machining. The training precision of the neural network benefits from large amounts of training data.

The pre-training data set is a collection of a plurality of samples, each of which comprises a value of at least one input and a value of at least one output, wherein the value of the output is determined by providing the value of the input to the physical model as input data. Logically, the number of nodes of the input layer of the neural network is the same as the number of the input and the number of the nodes of the output layer is the same as the number of the output.

In some applications, other parameters influence the outputs of the physical models and they are known with uncertainty. These parameters are defined as variable parameters and are derived from experiments or simulations. The variation range of the variable parameters can be defined by a reference value and a standard deviation.

In order to further improve the prediction precision, in particular to reduce the influence of the uncertainties of the variable parameters, at least two final-trained neural networks are obtained by training at least two neural networks independently using at least two different pre-training data sets. Each pre-training data set is generated by varying at least one variable parameter according to its uncertainty range. Each pre-training data set is generated by using same type of physical model.

The number of neural networks is independent on the number of variable parameters. Thus, the number of the neural network required can be as same as the number of the variable parameters, smaller or larger than the total number of variable parameters.

For example, the physical model includes Nᵢₙₜ inputs and M output parameters, wherein the number Nᵢₙₜ and M are integer. The neural network is selected to have an input layer with Nᵢₙₜ input nodes and an output layer with M output nodes.

If there are L variable parameters, wherein L is integer. Nₙₑₜ neural networks are trained to obtain Nₙₑₜ final-trained neural networks. For each of Nₙₑₜ neural network, a pre-training data set is generated by varying the value of at least one of the L variable parameters. In total, Nₙₑₜ pre-training data sets must be generated. In the pre-training phase, the Nₙₑₜ neural networks are trained individually by feeding one of the Nₙₑₜ pre-training data sets. Each pre-training data set includes a plurality of samples, which include all inputs and the corresponding outputs determined from the physical model considering specific values for the variable parameters. Different pre-training sets for different neural networks differ from each other in that the value of the at least one of the L variable parameters varies.

In order to keep the amount of the experimental data required low, the same final-training data set can be fed to all pre-trained neural networks. It is considerable to provide different final-training data sets to train the pre-trained neural networks to further improve the precision. For example, a plurality of experimental data sets can be derived from the different machine tools and/or under different machining conditions.

After the pre-trained neural network is trained using experimental data, the final-trained neural network is ready for utilization. From each final-trained neural network prediction data can be determined and thereby Nₙₑₜ prediction data sets can be gained from Nₙₑₜ final-trained neural networks. Optimized prediction data set having a high accuracy can be determined by averaging the prediction data set determined by each of Nₙₑₜ final-trained neural networks.

If an average of the plurality of prediction data set is calculated, the inaccuracy of the prediction caused by uncertainties of the variable parameters can be minimized. Furthermore, from the plurality of prediction results, the propagation of the uncertainty of the variable parameters on the final prediction can be estimated, so that the reliability of the prediction can be further increased. It is advantageous to determine a trimmed mean of the Nₙₑₜ prediction data sets.

The method of the present invention is suitable for many industry applications, in which the physical model cannot provide a sufficient prediction accuracy, for example for predicting the thermal behavior of a machine, the wear of components or the power consumption of a machine.

One particular application is predicting chatter occurrence in a machine tool. The predication data defines the chatter occurrence in a machine tool, in particular for milling or turning or grinding. Chatter vibrations are self-excited vibrations, caused by the interaction of the cutting edge of the tool with the surface of the workpiece to be machined. The chatter occurrence in milling process depends on the cutting coefficients, spindle speed, cutting depth and cutting width and the dynamics at the Tool Center Point of a cutting tool. One known method to predict the chatter occurrence is building a physical analytical model.

In this variant, the simulated data is obtained from a physical model describing stability. Such stability model requires four different inputs: the dynamics in the tool-workpiece contact zone, process information such as the engagement conditions, information about the tool geometry and the cutting coefficients, which relate the uncut chip thickness with the resulting cutting forces. While the tool geometry and the engagement conditions are usually known with sufficient precision, cutting coefficients and tooltip dynamics can be associated with high uncertainty.

In some embodiments, chatter is predicted using Deep Neural Networks (DNNs) having an input layer, an output layer and a plurality of hidden layers between input layer and output layer. The input layer includes one or more input nodes and the output layer includes one or more output nodes. In particular, hyperbolic tangent is used as the activation function for the hidden layers and/or softmax function is selected as the activation function of the output layers. However, any suitable neural network may be used to perform the method of the present invention.

The inputs include machining parameters such as axes position, axes feed direction, depth of cut, spindle speed and workpiece parameters, and the outputs include stability status. The prediction data set represent the chatter occurrence in a machine tool including stability status.

Several variable parameters are related the dynamics in the tool-workpiece contact zone e.g.: Young's modulus of a tool, Young's modulus of a holder, density of the tool, loss factor of the tool, loss factor of the holder, outer diameter equivalent cylinder of fluted section, translational tool-holder contact stiffness, rotational tool-holder contact stiffness, rotational tool-holder contact damping.

Additional variable parameters are tangential cutting coefficient and radial cutting coefficient.

In the application of chatter prediction, each input in the input layer of the neural network corresponds to one of the precisely known inputs describing the cutting process, e.g. spindle speed, depth of cut, entry angle, exit angle or clamping length and each output node in output layer corresponds to one outputs of the stability model, stable or chatter.

The method of the present invention can reduce the number of necessary experimental training data sets by approximately one order of magnitude while allowing the learning from and predictions for multiple dynamic configurations. This is achieved by utilizing transfer learning for Deep Neural Networks (DNNs). A multi-layer classification network is trained with artificial stability data generated using a simple dynamic model of the tool and holder and a stability model. This is done in order to make the neural network learn the general dependencies of the stability boundary on several influencing and easily measurable parameters. The pre-trained network is then fed with experimentally measured stability states and process conditions of arbitrary cuts to fine-tune the network with real data and allow for more accurate stability predictions in future processes. One of the main goals of the presented approach is to keep the measurement effort to a minimum, making it a promising approach for industry. The required experimental data for fine-tuning can simply be gathered during regular cutting operations.

Determining a stability lobe diagram from the final-trained neural network and/or prediction data can provide an improved visual presentation of the chatter occurrence in relation to different cutting conditions.

In the present invention, a prediction unit is configured to conduct the method disclosed in the present invention.

In the present invention, a machine tool comprises a controller, a monitoring unit and the prediction unit. The monitoring unit is connected to the controller and to the prediction unit. The monitoring unit is configured to detect and characterize the chatter occurrence during the machining based on the data provided by the controller and potential additional sensors and to prepare the experimental data to be fed into the prediction unit.

In the present invention, a system includes a plurality of machine tools and the prediction unit. The prediction data generated by the prediction unit can be shared between the machine tool. It is also possible to derive the experimental data from different machine tools included in the system. This has the advantage of efficiently collecting the experimental data and the collected experimental data can cover a variety of machining conditions.

### BRIEF DESCRIPTION OF THE DRAWINGS

In order to describe the manner in which advantages and features of the disclosure can be obtained, in the following a more particular description of the principles briefly described above will be rendered by reference to specific embodiments thereof which are illustrated in the appended drawings. These drawings depict only exemplary embodiments of the disclosure and are not therefore to be considered to be limiting of its scope. The principles of the disclosure are described and explained with additional specificity and detail through the use of the accompanying drawings in which:
- Fig. 1: illustrates a physical model;
- Fig. 2: illustrates a neural network;
- Fig. 3: illustrates pre-training, final training and prediction;
- Fig. 4 and Fig. 5: illustrates an example of physical model requiring uncertain parameters;
- Fig. 6: illustrates multiple neural networks; and
- Fig.7 and Fig. 8: illustrates a model for stability prediction;
- Fig.9: illustrates a stability lobe diagram; and
- Fig. 10 to Fig.14: illustrates one embodiment of prediction chatter occurrence.

### EXEMPLARY EMBODIMENTS

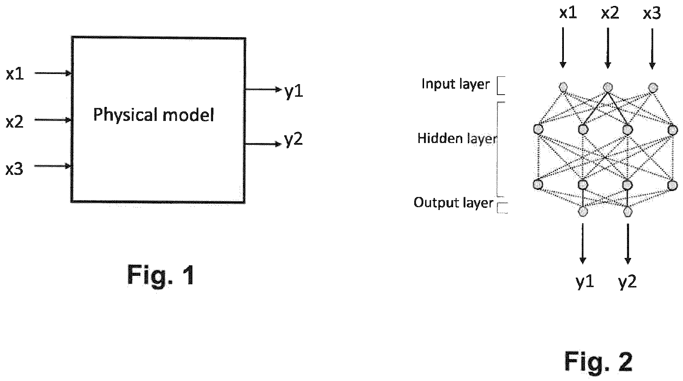

Figure 1, 2 and 3 illustrate one embodiment of the present invention based on transfer learning. Transfer learning describes a method where a model that has been trained on one problem is used as a starting point for a slightly different but related problem. Figure 1 depicts a schematic of a physical model comprising three inputs, x1, x2 and x3 and two outputs y1 and y2. The number of inputs and outputs is however not limited to these numbers shown in figure 1. A pre-training data set is derived from the physical model. The pre-training data set includes a large amount of samples for example in the range of 1000 to 10000. For different samples, different value of inputs are set to calculate the corresponding outputs.

During the pre-training, the pre-training data set is fed into a neural network shown in figure 2 having an input layer, several hidden layers and an output layer. The input layer has the same number of nodes as the inputs, namely three in this example. The output layer has the same number of outputs, namely two in this example.

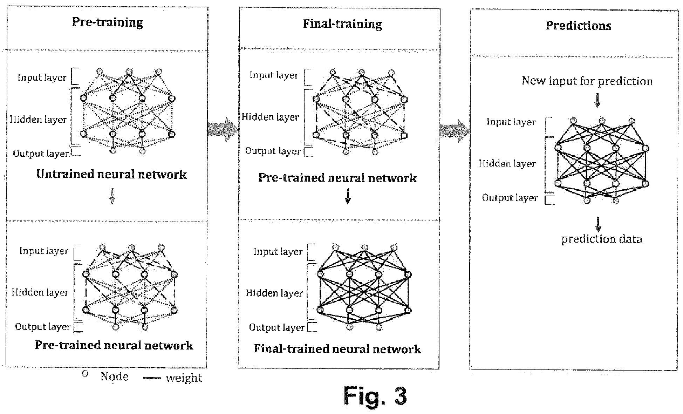

Figure 3 depicts an overview of pre-training phase, final-training phase and predictions. In the pre-training phase, the weights of the neural network are determined by utilizing the simulated data from the physical model and at the end of the pre-training phase a pre-trained neural network having determined weights is obtained. This pre-trained neural network is, hence, a mapping of the physical model and is aware of the main influencing factors and the general behavior of the physical model.

The pre-trained neural network having the determined weights is further trained in the final-training phase. Contrary to the pre-training phase, in this phase experimental data set is provided to adjust the weights determined in the pre-training phase to further improve the accuracy of the learning.

After the final-training, the final-trained neural network is ready to be deployed for prediction.

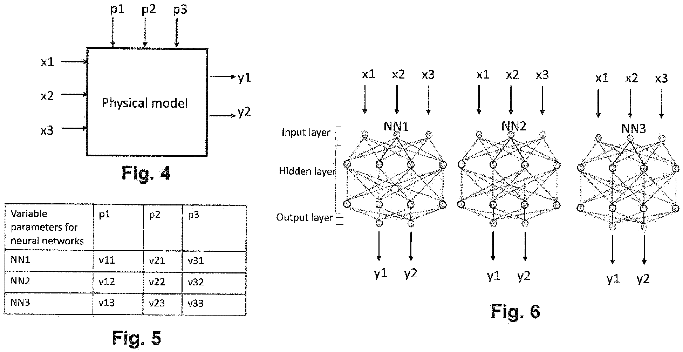

Figures 4, 5 and 6 show an embodiment by which the prediction accuracy can be further increased by training more than one neural network independently. Figure 4 illustrates an example of a physical model, which includes variable parameters having uncertainty. In addition to the inputs x1, x2 and x3 further variable parameters p1, p2 and p3 influence the output of the physical model. These parameters are not known precisely. The value of the variable parameters can vary in a range, thereby introduces uncertainty into the outputs and cause the reduction of the prediction accuracy. In order to minimize the influences considerable uncertainty on the prediction accuracy, a plurality of neural networks are applied. The three neural networks shown in figure 6 is merely to demonstrate that more than one neural networks is implemented, however, the number of neural networks is not limited to three.

Before starting the pre-training, pre-training data set must be generated using the physical model. In order to calculate the output of the model by varying the inputs, the values of the variable parameters must be pre-determined. Since the variable parameters are uncertain, different values of the variable parameters are selected to be used to determine pre-training data set for different neural networks. By this way, the negative influences of the uncertainty of the variable parameters on the final prediction results can be reduced. As shown in the figure 5, three groups of value of variable parameters p1, p2 and p3 are determined. For generating the simulated data set for NN1, the values v11, v21 and v31 are used. The plurality of samples are generated for NN1 by using the same values v11, v21 and v31 and varying the value of the inputs x1, x2 and x3. For generating the simulated data set for NN2, the values v12, v22 and v32 are used. The plurality of samples are generated for NN2 by using the same values v12, v22 and v32 and varying the value of the inputs x1, x2 and x3. For generating the simulated data set for NN3, the values v13, v23 and v33 are used. The plurality of samples are generated for NN3 by using the same values v13, v23 and v33 and varying the value of the inputs x1, x2 and x3.

At the end of pre-training phase, three pre-trained neural networks are obtained. In the final-training phase, the same experimental data are fed into the pre-trained neural networks. If sufficient experimental data are available, three different final-training data sets may also be an option. The three final-trained neural networks can be individually used to make the prediction. An optimized prediction data is determined by calculate the average of the prediction data sets obtained from each of the three final-trained neural networks.

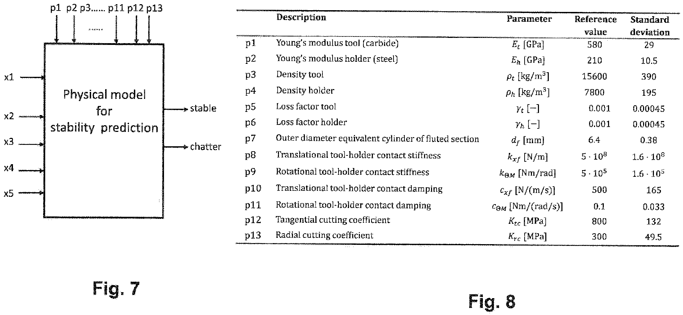

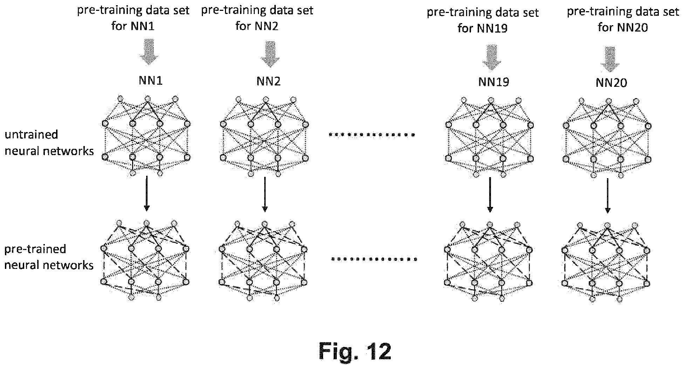

Figures 7 to 14, demonstrate an application of the method for chatter prediction. The physical model for stability prediction used for machine tool shown in figure 7, in particular for milling comprises five inputs: x1 as clamping length (S_{cl}), x2 as spindle speed (n), x3 as depth of cut (ap), x4 as entry angle (φₛₜ), and x5 as exit angle (φₑₓ). Additional information, namely variable parameters p1 to p13 to be provided to the model are listed in figure 8. These variable parameters are associated with uncertainty. The two output parameters of this physical model represent the two conditions: stable and chatter. The physical model provides a prediction if the machining under the given inputs runs stable or not. Typically, stability lobe diagrams are used to distinguish between stable and unstable cutting depths as a function of the spindle speed.

Each of the variable parameters has an estimated reference value. However, this value can vary in a range according to a given probabilistic model, which can be taken for a normal distribution from the value of standard deviation. The value shown in figure 8 is merely as exemplary purpose.

In a first step, pre-training data set is generated by selecting variable parameters, preparing inputs of the samples, feeding these inputs into an existing stability model such that output of stability model can be derived. For the generation of the simulated data set it is not directly clear which values for the variable parameters summarized in the figure 7 should be assumed in the modelling stage. Here, an extension to the classic transfer learning idea is applied, which takes the modelling uncertainty into account to further improve the accuracy of the chatter prediction. It is based on the idea of ensemble learning, where multiple networks are trained, and their individual estimates are combined to obtain a single prediction.

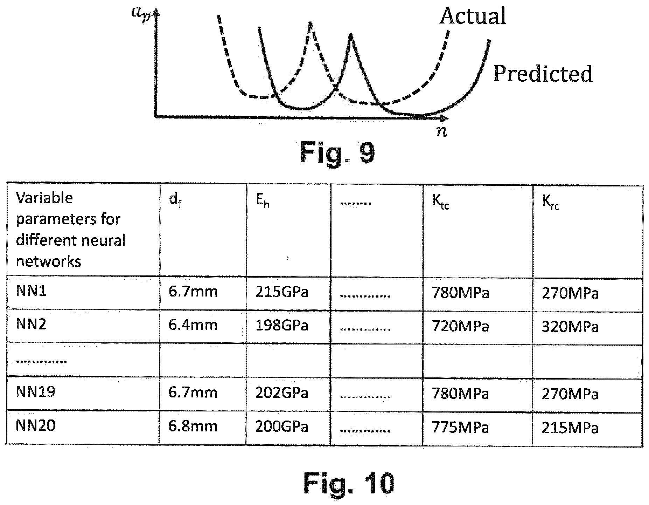

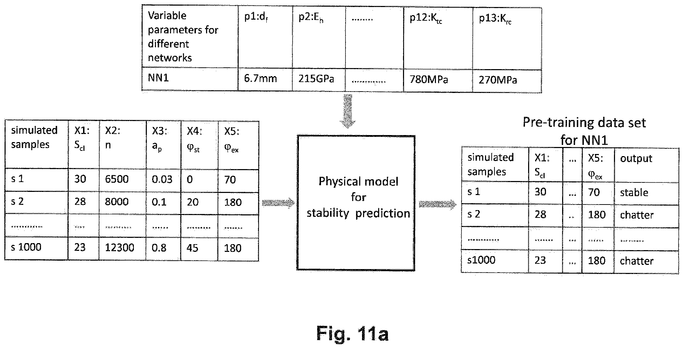

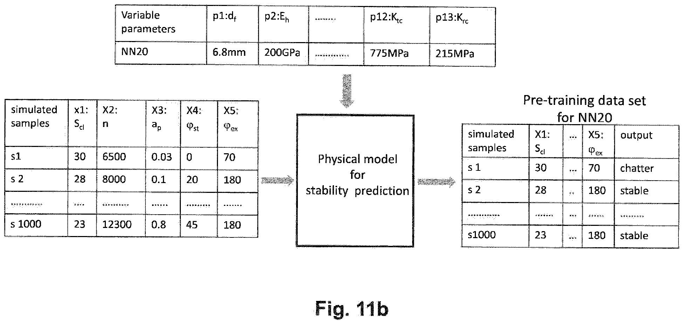

Figure 10 shows the selected variable parameters used to prepare different pre-training data set for different neural networks. All variable parameters are sampled 20 times from their distributions defined in figure 8, because 20 neural networks are applied. At the same time, 1000 simulated cutting samples are generated, where spindle speed, depth of cut, entry and exit angle are sampled uniformly from defined ranges. These ranges can be derived from the range of the experimental data set. For example, if the experimental data set was obtained with spindle speeds between 6000 rpm and 15000 rpm, the same range can be selected for the simulated data set. The generated pre-training data set consisting of the inputs spindle speed, depth of cut, entry and exit angle as well as the clamping length and the outputs stable/unstable are used for pre-training of one network. Figures 11a and 11b illustrate how to prepare the pre-training data set for NN1 and NN20. Each pre-training data set includes 1000 samples. Different values of the five inputs are fed into physical model to determine the output, while the same variable parameters for NN1 are used for all samples.

The generated pre-training data sets are then used for training the neural networks, in this example 20 neural networks are applied, however the number of the neural networks severs merely for exemplary purpose and is not limited to 20. The pre-trained neural networks are then aware of the main influences on the stability lobes and has also learnt the concept of stability pockets, which repeat with the spindle speed. Nevertheless, these networks may have a poor performance when comparing its predictions with actual experimental stability states.

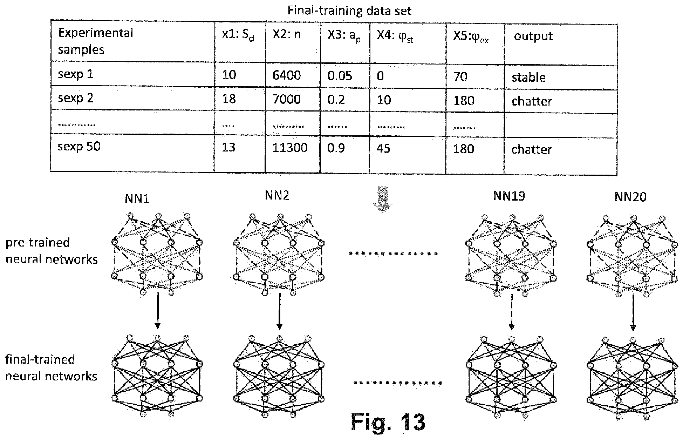

While with the simulated data it is targeted to make the neural network aware of the general shape of stability lobes shown in figure 9 and its basic dependencies, the goal of the fine-tuning is to compensate four sources of errors, which were possibly introduced in the pre-training stage: inaccuracy in the modelling of tool-workpiece contact zone dynamics, uncertainty about the cutting coefficients, potential operational changes of dynamics and cutting coefficients (e.g. spindle speed dependency) and the inaccuracies of the stability model used. This problem is solved in the fine-tuning stage. A much smaller experimental data set, e.g. 50 as shown in figure 13 is now fed to the pre-trained networks, whose initial weights are equal to the optimized network weights from the pre-training stage. The network weights will now adapt slightly to match the neural network predictions with the experimentally observed stability states.

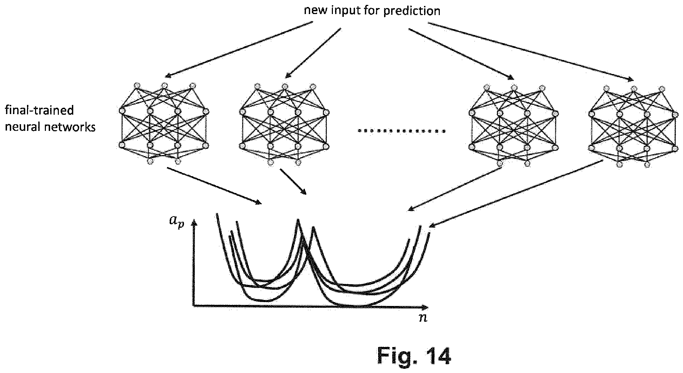

In the next step, the fine-tuned networks can be used for stability predictions of new cutting scenarios and much more accurate stability predictions are possible. Figure 14 shows utilizing multiple neural networks for prediction.

When predicting a stability chart for new process conditions, each of the networks makes a prediction. For example, the stability lobes shown in at the figure 14 are results from the different final-trained neural networks. All network predictions are averaged using a truncated mean approach, where very high and very low predictions are excluded.

## Claims

1. A method for predicting chatter occurrence of a machine tool, said method being performed by a prediction unit for a machine tool or for a plurality of machine tools, and comprising the following steps:
a) training a neural network having an input layer, at least one hidden layer, an output layer and a plurality of weights in a pre-training phase and a final-training phase, wherein in the pre-training phase a pre-training data set is provided to the neural network to obtain a pre-trained neural network and in the final-training phase a final-training data set is fed to the pre-trained neural network to obtain a final-trained neural network, wherein the pre-training data set comprises simulated data and is derived from a physical model including a plurality of inputs and a plurality of outputs and the final-training data set comprises experimental data, wherein the physical model is a stability model defining the chatter occurrence in the machine tool and the inputs include machining parameters, and the outputs are stability status of the machining operation, wherein at least two final-trained neural networks are obtained by training at least two neural networks independently using at least two different pre-training data sets and each pre-training data set is generated by varying at least one variable parameter, which is a part of input data of the physical model; and
b) performing prediction by utilizing the final-trained neural network to derive prediction data, wherein the optimized prediction data is determined by averaging the prediction data determined by using each final-trained neural network.

2. The method according to claim 1, wherein the weights of the pre-trained neural network determined during the pre-training phase are adapted in the final-training phase by utilizing the final-training data set.

3. The method according to claim 1 or 2, wherein the amount of the data included in the pre-training data set is larger than the amount of data included in the final-training data set.

4. The method according to one of claims 1 to 3, wherein the pre-training data set comprises exclusively simulated data generated using a physical model and/or the final-training data set comprises exclusively experimental data.

5. The method according to claim 4, wherein the pre-training data set is a collection of a plurality of samples, which includes a value of the at least one input and a value of the at least one output, wherein the value of the output is determined by providing the value of the input to the physical model as input data.

6. The method according to one of claims 1 to 5, wherein the variable parameters include one or more of the following: Young's modulus of a tool, Young's modulus of a holder, density of the tool, loss factor of the tool, loss factor of the holder, outer diameter equivalent cylinder of fluted section, translational tool-holder contact stiffness, rotational tool-holder contact stiffness, rotational tool-holder contact damping, tangential cutting coefficient and radial cutting coefficient.

7. The method according to one of claim 1 to 6, wherein the method further comprises determining a stability lobe diagram from the prediction data and/or optimized prediction data.

8. A prediction unit configured to conduct the method according to one of claims 1 to 7.

9. A machine tool comprising a controller configured to control the machine tool, a monitoring unit and, the prediction unit according to claim 8, wherein the monitoring unit is configured to detect and characterize the chatter occurrence during the machining and to prepare the experimental data to be fed into the prediction unit.

10. A system including a plurality of machine tools and a prediction unit according to claim 8.

## Patentansprüche

1. Verfahren zur Vorhersage des Auftretens von Rattern einer Werkzeugmaschine, wobei das Verfahren von einer Vorhersageeinheit für eine Werkzeugmaschine oder für mehrere Werkzeugmaschinen durchgeführt wird und die folgenden Schritte umfasst:
a) Trainieren eines neuronalen Netzes, das eine Eingabeschicht, mindestens eine verborgene Schicht, eine Ausgabeschicht und mehrere Gewichte aufweist, in einer Vortrainingsphase und einer finalen Trainingsphase, wobei in der Vortrainingsphase ein Vortrainingsdatensatz dem neuronalen Netz bereitgestellt wird, um ein vortrainiertes neuronales Netz zu erhalten, und in der finalen Trainingsphase ein finaler Trainingsdatensatz in das vortrainierte neuronale Netz eingespeist wird, um ein fertig trainiertes neuronales Netz zu erhalten, wobei der Vortrainingsdatensatz simulierte Daten umfasst und von einem physikalischen Modell abgeleitet wird, das mehrere Eingänge und mehrere Ausgänge aufweist, und der finale Trainingsdatensatz Versuchsdaten umfasst, wobei das physikalische Modell ein Stabilitätsmodell ist, welches das Auftreten von Rattern in der Werkzeugmaschine definiert, und die Eingangsgrößen Bearbeitungsparameter umfassen und die Ausgangsgrößen Stabilitätszustände des Bearbeitungsvorgangs sind, wobei mindestens zwei fertig trainierte neuronale Netze durch Trainieren von mindestens zwei neuronalen Netzen unabhängig voneinander unter Verwendung von mindestens zwei verschiedenen Vortrainingsdatensätzen erhalten werden und jeder Vortrainingsdatensatz erzeugt wird, indem mindestens ein variabler Parameter variiert wird, welcher ein Teil von Eingangsdaten des physikalischen Modells ist; und
b) Durchführen der Vorhersage, indem das fertig trainierte neuronale Netz verwendet wird, um Vorhersagedaten abzuleiten, wobei die optimierten Vorhersagedaten durch Mittelung der Vorhersagedaten bestimmt werden, die unter Verwendung der einzelnen fertig trainierten neuronalen Netze bestimmt wurden.

2. Verfahren nach Anspruch 1, wobei die Gewichte des vortrainierten neuronalen Netzes, die während der Vortrainingsphase bestimmt wurden, in der finalen Trainingsphase unter Verwendung des finalen Trainingsdatensatzes angepasst werden.

3. Verfahren nach Anspruch 1 oder 2, wobei die Menge der Daten, die in dem Vortrainingsdatensatz enthalten sind, größer als die Menge der Daten ist, die in dem finalen Trainingsdatensatz enthalten sind.

4. Verfahren nach einem der Ansprüche 1 bis 3, wobei der Vortrainingsdatensatz ausschließlich simulierte Daten umfasst, die unter Verwendung eines physikalischen Modells erzeugt wurden, und/oder der finale Trainingsdatensatz ausschließlich Versuchsdaten umfasst.

5. Verfahren nach Anspruch 4, wobei der Vortrainingsdatensatz eine Sammlung einer Vielzahl von Proben ist, welche jeweils einen Wert der mindestens einen Eingangsgröße und einen Wert der mindestens einen Ausgangsgröße enthalten, wobei der Wert der Ausgangsgröße bestimmt wird, indem der Wert der Eingangsgröße dem physikalischen Modell als Eingangsdaten bereitgestellt wird.

6. Verfahren nach einem der Ansprüche 1 bis 5, wobei die variablen Parameter einen oder mehrere der folgenden Parameter aufweisen: Elastizitätsmodul eines Werkzeugs, Elastizitätsmodul eines Halters, Dichte des Werkzeugs, Verlustfaktor des Werkzeugs, Verlustfaktor des Halters, Außendurchmesser des äquivalenten Zylinders des genuteten Abschnitts, translatorische Kontaktsteifigkeit Werkzeug-Halter, rotatorische Kontaktsteifigkeit Werkzeug-Halter, rotatorische Kontaktdämpfung Werkzeug-Halter, tangentialer Schnittkraftkoeffizient und radialer Schnittkraftkoeffizient.

7. Verfahren nach einem der Ansprüche 1 bis 6, wobei das Verfahren ferner das Bestimmen eines Stabilitätskeulendiagramms aus den Vorhersagedaten und/oder optimierten Vorhersagedaten umfasst.

8. Vorhersageeinheit, welche dafür ausgelegt ist, das Verfahren nach einem der Ansprüche 1 bis 7 durchzuführen.

9. Werkzeugmaschine, welche eine Steuereinheit, die dafür ausgelegt ist, die Werkzeugmaschine zu steuern, eine Überwachungseinheit und die Vorhersageeinheit nach Anspruch 8 umfasst, wobei die Überwachungseinheit dafür ausgelegt ist, das Auftreten von Rattern während der Bearbeitung zu erkennen und zu charakterisieren und die der Vorhersageeinheit zuzuführenden Versuchsdaten aufzubereiten.

10. System, welches mehrere Werkzeugmaschinen und eine Vorhersageeinheit nach Anspruch 8 umfasst.

## Revendications

1. Procédé de prédiction de survenue de broutage d'une machine-outil, ledit procédé étant réalisé par une unité de prédiction pour une machine-outil ou pour une pluralité de machines-outils, et comprenant les étapes suivantes :
a) l'entraînement d'un réseau neuronal ayant une couche d'entrée, au moins une couche cachée, une couche de sortie, et une pluralité de poids, dans une phase d'entraînement préalable et une phase d'entraînement final, dans lequel, dans la phase d'entraînement préalable, un ensemble de données d'entraînement préalable est fourni au réseau neuronal pour obtenir un réseau neuronal préalablement entraîné et, dans la phase d'entraînement final, un ensemble de données d'entraînement final est entrée dans le réseau neuronal préalablement entraîné pour obtenir un réseau neuronal finalement entraîné, dans lequel l'ensemble de données d'entraînement préalable comprend des données simulées et est dérivé d'un modèle physique incluant une pluralité d'entrées et une pluralité de sorties et l'ensemble de données d'entraînement final comprend des données expérimentales, dans lequel le modèle physique est un modèle de stabilité définissant la survenue de broutage dans la machine-outil et les entrées incluent des paramètres d'usinage, et les sorties sont un état de stabilité de l'opération d'usinage, dans lequel au moins deux réseaux neuronaux finalement entraînés sont obtenus en entraînant au moins deux réseaux neuronaux indépendamment en utilisant au moins deux différents ensembles de données d'entraînement préalable et chaque ensemble de données d'entraînement préalable est généré en variant au moins un paramètre variable, qui est une partie de données d'entrée du modèle physique ; et
b) la réalisation d'une prédiction en utilisant le réseau neuronal finalement entraîné pour dériver des données de prédiction, dans lequel les données de prédiction optimisées sont déterminées en effectuant la moyenne des données de prédiction déterminées en utilisant chaque réseau neuronal finalement entraîné.

2. Procédé selon la revendication 1, dans lequel les poids du réseau neuronal préalablement entraîné déterminé durant la phase d'entraînement préalable sont adaptés dans la phase d'entraînement final en utilisant l'ensemble de données d'entraînement final.

3. Procédé selon la revendication 1 ou 2, dans lequel la quantité des données incluses dans l'ensemble de données d'entraînement préalable est plus grande que la quantité de données incluses dans l'ensemble de données d'entraînement final.

4. Procédé selon l'une des revendications 1 à 3, dans lequel l'ensemble de données d'entraînement préalable comprend exclusivement des données simulées générées en utilisant un modèle physique et/ou l'ensemble de données d'entraînement final comprend exclusivement des données expérimentales.

5. Procédé selon la revendication 4, dans lequel l'ensemble de données d'entraînement préalable est une collection d'une pluralité d'échantillons, qui inclut une valeur de l'au moins une entrée et une valeur de l'au moins une sortie, dans lequel la valeur de la sortie est déterminée en fournissant la valeur de l'entrée au modèle physique en tant que données d'entrée.

6. Procédé selon l'une des revendications 1 à 5, dans lequel les paramètres variables incluent un ou plusieurs de ce qui suit : module de Young d'un outil, module de Young d'un porte-outil, densité de l'outil, facteur de perte de l'outil, facteur de perte du porte-outil, cylindre équivalent de diamètre extérieur de section cannelée, raideur de contact de porte-outil translationnelle, raideur de contact de porte-outil rotationnelle, amortissement de contact de porte-outil rotationnel, coefficient de coupe tangentiel, et coefficient de coupe radial.

7. Procédé selon un de la revendication 1 à 6, dans lequel le procédé comprend en outre la détermination d'un diagramme de stabilité des lobes à partir des données de prédiction et/ou données de prédiction optimisées.

8. Unité de prédiction configurée pour réaliser le procédé selon l'une des revendications 1 à 7.

9. Machine-outil, comprenant une unité de commande configurée pour commander la machine-outil, une unité de surveillance, et l'unité de prédiction selon la revendication 8, dans lequel l'unité de surveillance est configurée pour détecter et caractériser la survenue de broutage durant l'usinage et pour préparer les données expérimentales destinées à être entrées dans l'unité de prédiction.

10. Système, incluant une pluralité de machines-outils et une unité de prédiction selon la revendication 8.
